# EUROPEAN PATENT APPLICATION

(11) **EP 3 588 035 A1**
(43) Date of publication of application: **01.01.2020**
(21) Application number: 18180377.6
(22) Date of filing: 28.06.2018
(51) Int. Cl.: G01K 7/18, H01L 23/49, H01L 21/60

(54) **A WIRE BONDING ARRANGEMENT AND METHOD OF MANUFACTURING A WIRE BONDING ARRANGEMENT**

(71) Applicant: Heraeus Nexensos GmbH, 63450 Hanau (DE)
(72) Inventor: Wienand, Karlheinz, 63741 Aschaffenburg (DE); Asmus, Tim, 63450 Hanau (DE); Urfels, Stephan, 63450 Hanau (DE)
(74) Representative: Heraeus IP

(57) **Abstract**

The present invention relates to a wire bonding arrangement, in particular a wedge-bond (11) or a ball-bond (11') arrangement, comprising a platinum thin-film bond pad (3) and a substrate (7) of an electronic device, wherein the platinum thin-film bond pad (3) is formed on the substrate (7), and wherein the platinum thin-film bond pad (3) comprises a plurality of openings (5a-5n) in the surface of the platinum thin-film bond pad (3); a fired coating (9) comprising precious metal components comprising a silver, Ag, or a silver platinum, AgPt, or a silver palladium, AgPd or a gold, Au, material, wherein the fired coating (9) extends at least partly over the surface of the platinum thin-film bond pad (3) to achieve a coated surface; and a bonding wire (11,11') bonded to the coated surface of the platinum thin-film bond pad (3), wherein the bonding wire (11,11') has a diameter of 0,05 mm to 3 mm and comprises an aluminum, Al, or copper, Cu, material. The invention also relates to a method of manufacturing such a wire bonding arrangement.

## Description

### Field of the invention

The invention relates to a wire bonding arrangement, in particular a wedge-bond or a ball-bond arrangement, comprising a platinum thin-film bond pad and a substrate of an electronic device, wherein the platinum thin-film bond pad is formed on the substrate, and wherein the platinum thin-film bond pad comprises a plurality of openings in the surface of the platinum thin-film bond pad; a fired coating comprising precious metal components comprising a silver, Ag, or a silver platinum, AgPt, or a silver palladium, AgPd or a gold, Au, material, wherein the fired coating extends at least partly over the surface of the platinum thin-film bond pad to achieve a coated surface; and a bonding wire bonded to the coated surface of the platinum thin-film bond pad, wherein the bonding wire has a diameter of 0,05 mm to 3 mm and comprises an aluminum, Al, or copper, Cu, material. The invention also relates to a method of manufacturing such a wire bonding arrangement.

### Background of the invention

Bonding wires are used in the manufacture of electronic devices for electrically interconnecting an integrated circuit, a printed circuit board, transistors, diodes, and the like with pads or pins of a housing. While bonding wires were made almost exclusively from gold in the past, nowadays less expensive materials are used such as copper or aluminum material. For example, the manufacture and use of an alloyed copper wire is described in US 2013/0140084 A1. This change has been instigated by the rising cost of gold and the comparatively stable, and much lower, cost of copper and aluminum. While copper wires have better thermal and electrical properties than aluminum wires, aluminum wires have a higher current carrying capacity than copper wires.

However, ball-bonding as well as wedge-bonding of copper and aluminum wires both have their challenges. In particular, reliably bonding the wires to a platinum bond pad, for example the bond pad of an electronic device such as a thin-film resistance temperature sensor utilizing the linearity and low hysterics of platinum, is difficult, since the available AgPt Pastes or AgPd pastes do not sufficiently adhere to the platinum material. Nevertheless, bonding copper or aluminum wires to a platinum bond pad would be desirable, since it would allow to contact electronic devices, such as thin-film platinum based temperature sensors or resistors jointly with connecting power electronic devices in one single process step.

Therefore, the invention aims at providing a solution for reliably bonding copper or aluminum bonding wires to a platinum bond pad.

### Summary of the invention

The invention provides a wire bonding arrangement, in particular a wedge-bond or a ball-bond arrangement, comprising:
a platinum thin-film bond pad and a substrate of an electronic device, wherein the platinum thin-film bond pad is formed on the substrate, and wherein the platinum thin-film bond pad comprises a plurality of openings in a surface of the platinum thin-film bond pad;
a fired coating comprising precious metal components comprising a silver, Ag, or a silver platinum, AgPt, or a silver palladium, AgPd or a gold, Au, material, wherein the fired coating extends at least partly over the surface of the platinum thin-film bond pad to achieve a coated surface; and
a bonding wire bonded to the coated surface of the platinum thin-film bond pad, wherein the bonding wire has a diameter of 0,05 mm to 3 mm and comprises an aluminum, Al, or copper, Cu, material.

The wire bonding arrangement can be manufactured by wedge-bonding or ball-bonding based on the physical constraints of the electronic devices such as, for example, temperature limitations. Typically, ball-bonding applications are associated with thermocompression and thermosonic joining methods. Thermocompression utilizes pressure and temperature from about 150° C to create an intermetallic bond. Wedge-bonding, on the other hand, utilizes ultrasonic energy and pressure to create a bond between the wire and the bond pad. Wedge bonding typically uses temperatures up to 150° C.

The term "openings" can be used to refer to through-holes in the surface of the platinum material, or to indentations in the surface of the platinum material that can vary from shallow to deep. The openings can be arranged in the surface of the platinum material that faces the fired coating. The openings can be dispersed regularly or randomly in said surface. A substrate having a platinum thin-film bond pad comprising a plurality of openings formed on the substrate has a first part of its surface covered with platinum material while a second part remains uncovered.

When coating a platinum thin-film comprising openings, the precious material of the coating can adhere to the uncovered second parts of the surface of the substrate when the coating is fired. Advantageously, the openings allow to contact platinum thin-film bond pads with an Al or Cu bonding-wire.

The electronic device can be in one example a platinum thin-film temperature sensor such as the temperature sensor that is described in US 2003/174041 A1. In the latter case, the platinum thin-film bond pad can be one of the contact pads of the temperature sensor. In a further example, the electronic device can be a thin-film platinum based resistor or a thick-film based resistor. In the aforementioned case, the platinum thin-film bond pad can be one of the contact pads of the resistor. Also, in an example of the invention the thick-film based resistor can be the thin-film bond pad. In the latter example, the resistor and the pad can be realized in a single component.

The term "fired coating" can be used herein to refer to a coating that is initially applied as a powder or fluid and then fired or baked to react with other chemical groups in the powder or fluid to create the final coating.

It has been advantageously found that a platinum thin-film bond pad with openings comprising a fired coating comprising precious metal components comprising a silver, Ag, or a silver platinum, AgPt, or a silver palladium, AgPd or a gold, Au, material, can be reliably contacted with an Al or Cu bonding-wire using a wedge-bonding or ball-bonding technique.

In particular, correspondingly created wire bond connections offer high electrical conductivity as well as good mechanical strength.

Also, advantageously, by being able to utilize just one single wire type and wire strength for jointly connecting thin-film platinum based temperature sensors and further electronic devices, the bonding machine used does not need to switch between these different wire types and strengths.

In one embodiment, the substrate is a ceramic substrate, most preferably a substrate comprising an aluminum oxide, Al2O3, material. In an embodiment thereof, the wire bonding arrangement comprises a circuit-board, wherein the substrate is sintered onto the circuit board.

In a further embodiment, the height of the thin-film bond pad, the substrate and/or fired coating is/are determined to match the height of at least one of the components, preferably the height of a sensor, arranged in the vicinity of the wire bonding arrangement on the substrate.

Advantageously, by adjusting the height/heights of the thin-film bond pad, the substrate and/or coating to correspond to the heights of components to be bonded in their vicinity, allows to operate the bonding device, in particular the head of the bonding device, in only one horizontal plane.

In another embodiment, the platinum thin-film bond pad is formed on the substrate and a thin film thickness of the thin-film bond pad is in a range between 0,05 µm to 1 µm.

In an embodiment, the openings comprise slits, perforations, holes having a generally polygonal shape, holes having a generally oval shape and/or holes having a generally circular shape, and/or wherein a bonding area of the platinum thin-film bond pad comprising openings covers 20% to 80% of the overall bonding area of the platinum thin-film bond pad.

In another embodiment, the fired coating further comprises an adhesion promoter, in particular a glass frit or a metal oxide of 5 to 10 wt.-% with respect to the total mass of the fired coating. Typical components of the glass frit are for example lead oxide, PbO2, bismuth oxide, Bi2O3, alkaline oxide, alkaline earth oxide and similar oxides. Typical components of metal oxides are for example silicon dioxide, SiO2, magnesia, MgO.

Advantageously, adding an adhesion promoter to the material of the coating before firing the coating, further enhances the quality of the contact between the fired coating and the ceramic substrate.

In an embodiment, the fired coating comprises:
- a silver material of 80 to 99,5 wt.-%, and a platinum material of 0,5 to 20 wt.-%, or
- a silver material of 60 to 95 wt.-% and a palladium material of 5 to 40 wt.-% with respect to the total mass of the precious metal components.

In another embodiment, the bonding wire comprises a copper material, Cu, and is coated with a noble metal, in particular with Titanium, Ti, or Nickel, Ni, or Chromium, Cr. In an alternative embodiment the bonding wire comprises an aluminum material and is coated with an alloy, in particular with an alloy of Aluminum-Silicon, AlSi.

By coating the different bonding wires, the electrical and thermal conductivity of the wires can be improved as well as the bondability of the wire on the coated surface of the platinum thin-film bond pad. Also, a coated bonding wire has improved resistance to corrosion and/or oxidation.

In an embodiment, the electronic device comprises a thin-film platinum based temperature sensor, a thin-film platinum based resistor, or a thick-film based resistor. In further embodiments, the electronic device can be a thin-film platinum based temperature sensor, a thin-film platinum based resistor, or a thick-film based resistor.

The invention also relates to a method of manufacturing a wire bonding arrangement, in particular a wedge-bond or a ball-bond arrangement, comprising the subsequent steps:
forming a platinum thin-film bond pad on a substrate of an electronic device;
inserting openings in a surface of the platinum thin-film bond-pad;
applying to the platinum thin-film bond pad a paste comprising precious metal components, comprising a silver, Ag, or a silver platinum, AgPt, or a silver palladium, AgPd or a gold, Au, material,
firing the paste to achieve a fired coating, wherein the fired coating extends at least partly over the surface of the platinum thin-film bond pad; and
wire bonding a bonding wire to the coated surface of the platinum thin-film bond pad, wherein the bonding wire has a diameter of 0,05 mm to 3 mm and comprises an aluminum, Al, or copper, Cu, material.

In one embodiment, the method comprises the steps:
- forming the platinum thin-film bond pad by means of physical vapor deposition, in particular evaporation or sputtering, and/or
- inserting the openings in the surface of the of the platinum thin-film bond pad by means of photo lithography or laser ablation, and/or
- coating the platinum thin-film bond pad by applying the paste comprising the precious metal components on the surface of the thin-film bond pad, and/or
- drying the paste at 150°C for 10 to 15 minutes, and/or
- firing the paste at 850 °C for 10 minutes, and with a total firing cycle time of 30 minutes to 60 minutes to achieve the coating.

All of the method steps mentioned in the embodiment described above can be carried out subsequently in the order described as defined. However, in embodiments of the invention, one or more method steps can be omitted and/or replaced with an alternative step(s).

In one embodiment, the paste is applied by a screen printing process, comprising the successive processing steps:
- printing the paste through a 200 to 325 mesh stainless steel screen, and
- leveling the paste at room temperature for 5 to 10 minutes.

In another embodiment, the method comprises prior to wire bonding the bonding wire the step:
- coating the bonding wire comprising a copper material with a noble metal, in particular with Titanium, Ti, or Nickel, Ni, or Chromium, Cr, or
- coating the bonding wire comprising an aluminum material with an alloy, in particular with an Aluminum-Silicon, AISi, Alloy.

Also, in one embodiment, the wire bonding of the bonding wire to the coated surface of the platinum thin-film bond pad is done by ultrasonic vibration.

### Brief description of the drawings

The following schematic drawings show aspects of the invention for improving the understanding of the invention in connection with some exemplary illustrations, wherein
- **Figures 1 and 2**: show schematic views of two wire bonding arrangements according to examples of the invention; and
- **Figures 3 to 5**: show method steps according to examples of the invention.

### Detailed description

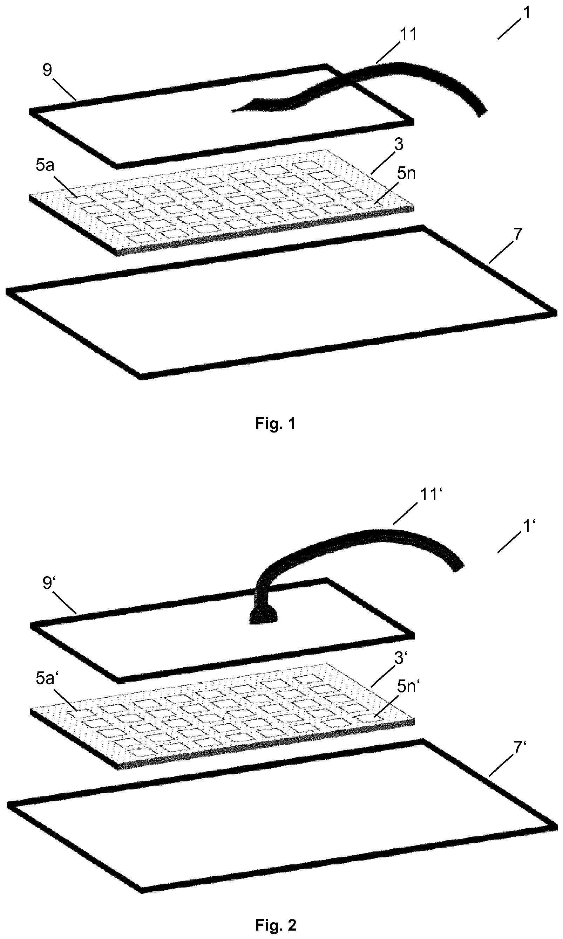

Figure 1 shows a wedge-bond wire bonding arrangement 1. The wire bonding arrangement 1 comprises a substrate 7 of an electronic device (not shown in figure 1).

In the shown embodiment, the substrate 7 is a ceramic substrate comprising an aluminum oxide, Al2O3, material. However, in further embodiments the substrate can comprise other materials as well. For example, the substrate can be a semiconductor. Also, in further examples, the substrate can be sintered onto a circuit board.

As it can be seen from figure 1, the platinum thin-film bond pad 3 is formed on the substrate 7. The platinum thin-film bond pad 3 can be formed by means of physical vapor deposition such as evaporation or sputtering. The thickness of the resulting thin-film can be in a range between 0,05 µm to 1 µm. The platinum thin-film bond pad 3 comprises a plurality of openings 5a - 5n in the surface of the platinum thin-film bond pad 3. The openings 5a - 5n in the surface of the platinum thin-film can be inserted by means of photo lithography or laser ablation.

In the shown embodiments the openings 5a - 5n are shown as a perforation comprising a plurality of rectangular openings. In other embodiments, not shown in the figures, the openings can comprise slits, holes having a generally polygonal shape, holes having a generally oval shape and/or holes having a generally circular shape.

As it can be seen from the figure, the bonding area of the platinum thin-film bond pad 3 comprises openings 5a - 5n covers approximately 50% of the overall bonding area of the platinum thin-film bond pad 3.

Figure 1 further shows the fired coating 9 arranged on top of the thin-film bond pad 3. The fired coating 9 comprises precious metal components comprising a silver, Ag, or a silver platinum, AgPt, or a silver palladium, AgPd or a gold, Au, material, and extends over the surface of the platinum thin-film bond pad 3 that faces the fired coating 9. The fired coating 9 can also comprise an adhesion promoter, such as a glass frit or a metal oxide of 5 to 10 wt.-% with respect to the total mass of the coating 9.

The platinum thin-film bond pad 3 with openings 5a - 5n and having a fired coating 9 arranged thereon allows to contact the thin-film bond pad 3 with an Al or Cu bonding-wire 11. In the shown embodiment, the bonding wire 11 is attached to the thin-film bond pad 3 by wedge-bonding. The bonding wire 11 has a diameter of 0,05 mm to 3 mm and comprises an aluminum, Al, or copper, Cu, material.

Figure 2 shows a ball-bond wire bonding arrangement 1'. The wire bonding arrangement 1' corresponds to the arrangement shown in figure 1, and only differs from the arrangement shown in figure 1 in that the bonding wire 1' is attached to the thin-film bond pad 3' by means of a ball-bonding technique.

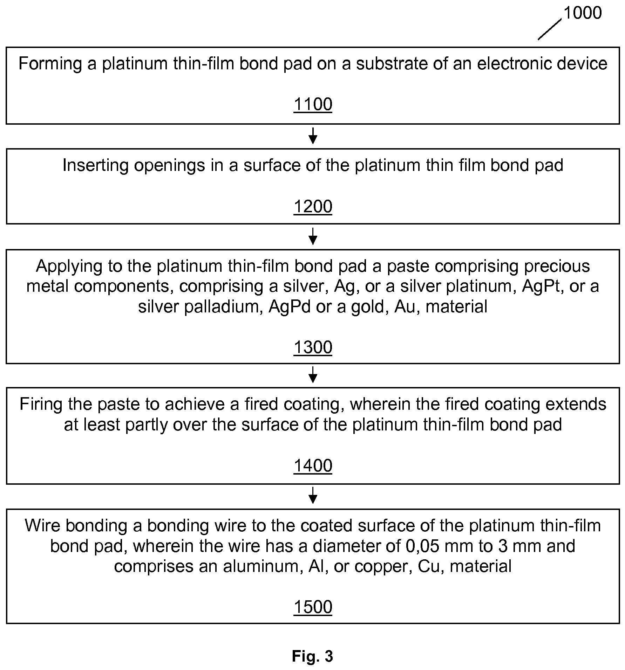

Figures 3 to 4 show method steps according to examples of the invention.

Figure 3 shows a method 1000 of manufacturing a wire bonding arrangement, in particular a wedge-bond or a ball-bond arrangement, according to the invention. The method 1000 comprises the subsequent steps:
Forming 1100 a platinum thin-film bond pad on a substrate of an electronic device;
Inserting 1200 openings in a surface of the platinum thin-film bond pad;
Applying 1300 to the platinum thin-film bond pad a paste comprising precious metal components, comprising a silver, Ag, or a silver platinum, AgPt, or a silver palladium, AgPd or a gold, Au, material;
Firing 1400 the paste to achieve a fired coating, wherein the coating extends at least partly over the surface of the platinum thin-film bond pad; and
Wire bonding 1500 a bonding wire to the coated surface of the platinum thin-film bond pad, wherein the wire has a diameter of 0,05 mm to 3 mm and comprises an aluminum, Al, or copper, Cu, material.

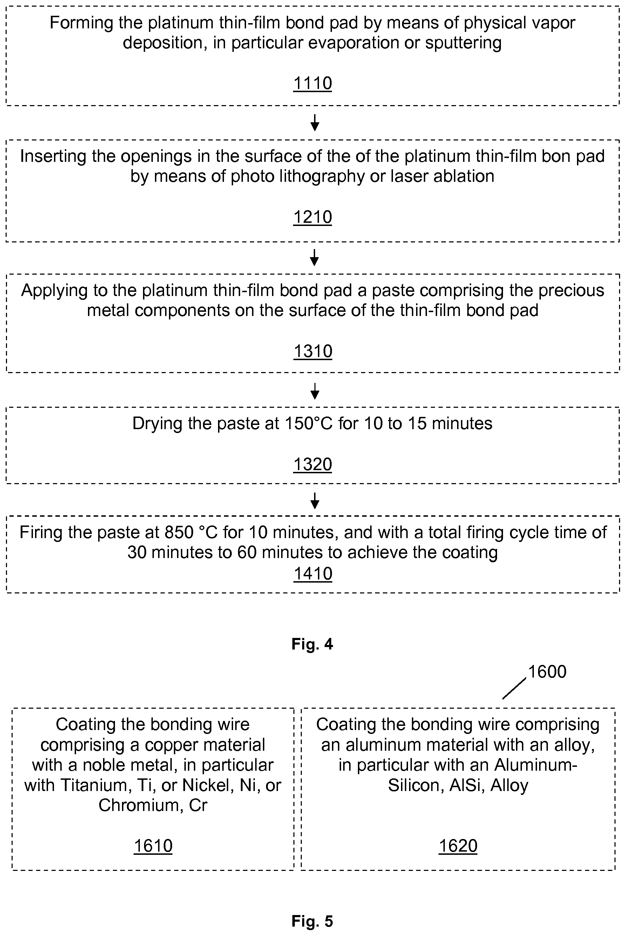

Figure 4 shows optional method steps. The optional steps can comprise all or just one of the following steps:
Forming 1110 the platinum thin-film bond pad by means of physical vapor deposition, in particular evaporation or sputtering, and/or
Inserting 1210 the openings in the surface of the of the platinum thin-film bond pad by means of photo lithography or laser ablation, and/or
Applying 1310 to the platinum thin-film bond pad a paste comprising the precious metal components on the surface of the thin-film bond pad, and/or
Drying 1320 the paste at 150°C for 10 to 15 minutes, and/or
Firing 1410 the paste at 850 °C for 10 minutes, and with a total firing cycle time of 30 minutes to 60 minutes to achieve the coating.

Figure 5 shows optional methods steps for Coating 1600 the bonding wire. In this example, the method comprises prior to wire bonding the bonding wire the step:
Coating 1610 the bonding wire comprising a copper material with a noble metal, in particular with Titanium, Ti, or Nickel, Ni, or Chromium, Cr, or
Coating 1620 the bonding wire comprising an aluminum material with an alloy, in particular with an Aluminum-Silicon, AlSi, Alloy.

### Examples

The invention is further exemplified by examples. These examples serve for exemplary elucidation of the invention and are not intended to limit the scope of the invention or the claims in any way.

### Example 1

In a first example, the platinum thin-film bond pad is formed on a substrate comprising an aluminum oxide. First, the platinum thin-film is deposited by means of vapor deposition on the substrate. After evaporating the platinum thin-film, a plurality of openings, or perforations, are made in the surface of the platinum thin-film with a photolithographic technique, where the openings are dry etched.

In the example, the rectangular dimension of the platinum thin-film bond pad are 2,0 mm x 1,1 mm. The platinum thin-film bond pad comprises two grid areas having 7 x 9 rectangular openings, and which are 70 µm x 70 µm.

### Example 2

In a second example, the platinum thin-film bond pad is the platinum thin-film bond pad of example 1, however, without comprising the openings.

### Example 3

In a third example, a paste comprising silver platinum, AgPt, is applied on the thin-film bond pad of example 1 or example 2. The paste further comprises an adhesion promoter in form of a glass frit of 5 to 10 wt.-% with respect to the total mass of the paste. Afterwards, the paste is dried and then fired at 850 °C to achieve the fired coating on the platinum thin-film bond pad.

It has been shown that the coating sticks only sufficiently well to the platinum thin-film bond pad according to example 1.

### Example 4

In a fourth example, an aluminum bonding wire is bonded onto the thin-film bond pad according to example 1, 2 and 3. A standard wire bonding machine from Fa. Kulicke & Soffa is employed to wedge bond Al-wire of type Al-H11, 300µm.

It has been shown that the wedge bonding of an Al-wire on a platinum thin-film according to examples 1 and 2 will not lead to stable connects. The bonded Al-wire will not adhere to platinum thin-films. In contrast, if the platinum thin film is coated with a silver platinum layer according to example 3 stable connects are achieved.

### Example 5

In a fifth example the beneficial effects of the wire bonding arrangement is confirmed by a standard pull test. The mechanical strength of the resulting wire bonding arrangement according to example 4 was measured by variation of the applied wedge bonding force. Table 1 below shows a list of measured data for different bonding forces:

**Table 1**

| | **Bonding Force [Digit US]** | **Shearing Force [gram-force]** | **Pull-Test [gram-force]** | **Standard Deviation of Pull-Test [gram-force]** | **Number of Cracks in Loop** | **Number of Cracks in Heel** |
|---|---|---|---|---|---|---|
| Example 1 | 35-50 | No adhesion of the Al-wire to platinum thin film | | | | |
| Example 2 | 35-50 | No adhesion of the Al-wire to platinum thin film | | | | |
| Example 3 | 35 | 442 | 283-296 | 9-12 | 19 | 1 |
| Example 3 | 40 | 483 | 283-296 | 9-12 | 20 | 0 |
| Example 3 | 45 | 516 | 283-296 | 22 | 20 | 0 |
| Example 3 | 50 | 525 | 283-296 | 9-12 | 18 | 2 |

It becomes clear from table 1 that wire bond connections according to the present invention have superior mechanical strength. Advantageously, the invention allows to reliably contact platinum thin-film bond pads with an Al or Cu bonding-wire using a wedge-bonding or ball-bonding technique.

The features disclosed in the claims, the specification, and the drawings maybe essential for different embodiments of the claimed invention, both separately or in any combination with each other.

### Reference Signs

- 1, 1': Wire Bonding Arrangement
- 3, 3': Thin-Film Bond Pad
- 5a - 5n, 5a' - 5n': Openings
- 7, 7': Substrate
- 9, 9': Fired Coating
- 11, 11': Bonding-Wire
- 1000: Method of Manufacturing a Wire Bonding Arrangement
- 1100: Forming
- 1110: Forming by Means of Physical Vapor Deposition
- 1200: Inserting
- 1210: Inserting by Means of Photo Lithography or Laser Ablation
- 1300: Applying
- 1310: Applying to the Surface
- 1320: Drying the Paste
- 1400: Firing
- 1410: Firing at 850 °C for 10 minutes
- 1500: Wire Bonding
- 1600: Coating the Bonding Wire
- 1610: Coating the Bonding Wire comprising a Copper Material
- 1620: Coating the Bonding Wire comprising an Aluminum Material

## Claims

1. A wire bonding arrangement, in particular a wedge-bond or a ball-bond arrangement, comprising:
a platinum thin-film bond pad and a substrate of an electronic device, wherein the platinum thin-film bond pad is formed on the substrate, and wherein the platinum thin-film bond pad comprises a plurality of openings in a surface of the platinum thin-film bond pad;
a fired coating comprising precious metal components comprising a silver, Ag, or a silver platinum, AgPt, or a silver palladium, AgPd or a gold, Au, material, wherein the fired coating extends at least partly over the surface of the platinum thin-film bond pad to achieve a coated surface; and
a bonding wire bonded to the coated surface of the platinum thin-film bond pad, wherein the bonding wire has a diameter of 0,05 mm to 3 mm and comprises an aluminum, Al, or copper, Cu, material.

2. The wire bonding arrangement of claim 1, wherein the substrate is a ceramic substrate, most preferably a substrate comprising an aluminum oxide, Al2O3, material.

3. The wire bonding arrangement of claim 2, comprising a circuit-board, wherein the substrate is sintered onto the circuit board.

4. The wire bonding arrangement of claim 3, wherein the height of the thin-film bond pad, the substrate and/or fired coating is/are determined to match the height of at least one of the components, preferably the height of a sensor, arranged in the vicinity of the wire bonding arrangement on the substrate.

5. The wire bonding arrangement of any of the preceding claims, wherein a thin film thickness of the thin-film bond pad is in a range between 0,05 µm to 1 µm.

6. The wire bonding arrangement of any of the preceding claims, wherein the openings comprise slits, perforations, holes having a generally polygonal shape, holes having a generally oval shape and/or holes having a generally circular shape, and/or wherein a bonding area of the platinum thin-film bond pad comprising openings covers 20% to 80% of the overall bonding area of the platinum thin-film bond pad.

7. The wire bonding arrangement of any of the preceding claims, wherein the fired coating further comprises an adhesion promoter, in particular a glass frit or a metal oxide of 5 to 10 wt.-% with respect to the total mass of the fired coating.

8. The wire bonding arrangement of any of the preceding claims, wherein the fired coating comprises:
• a silver material of 80 to 99,5 wt.-%, and a platinum material of 0,5 to 20 wt.-%, or
• a silver material of 60 to 95 wt.-% and a palladium material of 5 to 40 wt.-% with respect to the total mass of the precious metal components.

9. The wire bonding arrangement of any of the preceding claims, wherein the bonding wire comprises a copper material, Cu, and is coated with a noble metal, in particular with Titanium, Ti, or Nickel, Ni, or Chromium, Cr, or wherein the bonding wire comprises an aluminum material and is coated with an alloy, in particular with an alloy of Aluminum-Silicon, AlSi.

10. The wire bonding arrangement of any of the preceding claims, wherein the electronic device comprises a thin-film platinum based temperature sensor, a thin-film platinum based resistor, or a thick-film based resistor.

11. A method of manufacturing a wire bonding arrangement, in particular a wedge-bond or a ball-bond arrangement, comprising the subsequent steps:
forming a platinum thin-film bond pad on a substrate of an electronic device;
inserting openings in a surface of the platinum thin-film bond pad;
applying to the platinum thin-film bond pad a paste comprising precious metal components, comprising a silver, Ag, or a silver platinum, AgPt, or a silver palladium, AgPd or a gold, Au, material;
firing the paste to achieve a fired coating, wherein the fired coating extends at least partly over the surface of the platinum thin-film bond pad; and
wire bonding a bonding wire to the coated surface of the platinum thin-film bond pad, wherein the bonding wire has a diameter of 0,05 mm to 3 mm and comprises an aluminum, Al, or copper, Cu, material.

12. The method of claim 11, comprising:
• forming the platinum thin-film bond pad by means of physical vapor deposition, in particular evaporation or sputtering, and/or
• inserting the openings in the surface of the of the platinum thin-film bond pad by means of photo lithography or laser ablation, and/or
• applying to the platinum thin-film bond pad by a paste comprising the precious metal components on the surface of the thin-film bond pad, and/or
• drying the paste at 150°C for 10 to 15 minutes, and/or
• firing the paste at 850 °C for 10 minutes, and with a total firing cycle time of 30 minutes to 60 minutes to achieve the coating.

13. The method of claim 12, wherein the paste is applied by a screen printing process, comprising the successive processing steps:
• printing the paste through a 200 to 325 mesh stainless steel screen, and
• leveling the paste at room temperature for 5 to 10 minutes.

14. The method of claims 11 to 13, comprising prior to wire bonding the bonding wire the step:
• coating the bonding wire comprising a copper material with a noble metal, in particular with Titanium, Ti, or Nickel, Ni, or Chromium, Cr, or
• coating the bonding wire comprising an aluminum material with an alloy, in particular with an Aluminum-Silicon, AISi, Alloy.

15. The method of claims 11 to 14, wherein the wire bonding of the bonding wire to the coated surface of the platinum thin-film bond pad is done by ultrasonic vibration.
